# EUROPÄISCHE PATENTSCHRIFT

(11) **EP 2 356 518 B1**
(45) Veröffentlichungstag und Bekanntmachung des Hinweises auf die Patenterteilung: **02.01.2019**
(21) Anmeldenummer: 09748077.6
(22) Anmeldetag: 23.10.2009
(51) Int. Cl.: G03F 7/20

(54) **VERFAHREN UND VORRICHTUNG ZUR BEBILDERUNG EINES STRAHLUNGSEMPFINDLICHEN SUBSTRATS**
METHOD AND DEVICE FOR IMAGING A RADIATION-SENSITIVE SUBSTRATE
PROCEDE ET DISPOSITIF D'IMAGERIE D'UN SUBSTRAT SENSIBLE AU RAYONNEMENT

(30) Priorität: 19.11.2008 DE 102008058241; 07.05.2009 DE 102009020320
(43) Veröffentlichungstag der Anmeldung: 17.08.2011
(73) Patentinhaber: Heidelberg Instruments Mikrotechnik GmbH, 69126 Heidelberg (DE)
(72) Erfinder: WIJNAENDTS VAN RESANDT, Roelof, 76684 Odenheim (DE); KAPLAN, Roland, 69126 Heidelberg (DE)
(74) Vertreter: Wesch, Arno
(86) Internationale Anmeldenummer: PCT/EP2009/063959
(87) Internationale Veröffentlichungsnummer: WO 2010/057740

(56) Entgegenhaltungen:
- US-A1- 2005 168 851
- US-A1- 2006 176 323

## Beschreibung

Die Erfindung bezieht sich auf ein Verfahren zur Bebilderung eines strahlungsempfindlichen Substrats mit den Merkmalen gemäß dem Oberbegriff des Anspruchs 1 und auf eine Vorrichtung zur Bebilderung eines strahlungsempfindlichen Substrats mit den Merkmalen gemäß dem Oberbegriff des Anspruchs 8.

Aus der US 2005/0 168 851 A1 ist ein Verfahren bekannt, bei welchem nicht zusammenhängende Teilbilder zu einem Gesamtbild zusammengesetzt werden.

Die US 2006/0 176 323 A1 offenbart ein Verfahren und ein optisches System zum Projizieren eines Bildes mit x- und y-Achsen auf eine Bildebene. Pixel des projizierten Bilds sind im Wesentlichen um 45° zu den x- und y-Achsen des Bildes geneigt.

In einem bekannten Verfahren zur Bebilderung eines strahlungsempfindlichen Substrats wird eine programmierbare Vorlage mit kohärenter Strahlung beleuchtet und mittels eines optischen Systems auf das für die verwendete Strahlung empfindliche Substrat projiziert. Die programmierbare Vorlage kann zum Beispiel ein steuerbares Mikrospiegelarray sein, dessen Einzelelemente räumlich getrennt abgebildet werden. Das optische System, aufgebaut aus mindestens zwei unabhängigen Linsengruppen, erzeugt ein passend skaliertes Bild auf dem Substrat durch Überlagerung der Einzelbilder jedes Einzelelementes.

Aus der Eigenschaft der kohärenten Strahlung ergeben sich, insbesondere bei zu geringer Auflösung des optischen Systems, unerwünschte Interferenz-Effekte, welche die Qualität der erzeugten Strukturen beeinträchtigen. Bei hoher Auflösung ergibt sich eine geringe Überlagerung der Einzelbilder, so dass die Interferenz-Effekte vernachlässigbar sind. Durch diese geringe Überlappung ist es jedoch nicht möglich, eine Verschiebung von Strukturkanten auf dem Substrat durch Variation der Strahlungsintensität benachbarter Einzelbilder zu erreichen. Ein mechanisches Verfahren, welches mehrfache Belichtungsvorgänge benötigt, wurde im Dokument DE 10 2008 017 623 A1 beschrieben.

Aus dem Dokument US 4,541,712 geht eine Vorrichtung zur Erzeugung eines Lasermusters hervor, in welcher eine Mehrzahl von Laserlichtquellen in einem nichtinterferierenden Feld dicht angeordnet sind. Mittels eines akustisch-optischen Deflektors werden die emittierten Laserlichtstrahlen gleichzeitig über eine Region einer Zieloberfläche gescannt. Die Zieloberfläche wird nach einem erfolgten Arbeitstakt senkrecht zur Scanrichtung bewegt, um eine Repositionierung für den nächsten Arbeitstakt vorzunehmen.

Im Dokument US 6,552,779 B2 ist ein maskenloses Belichtungssystem für die digitale Fotolithographie beschrieben. Ein Feld von Spiegeln ist digital ansteuerbar, so dass ein Lichtmuster im von den Spiegeln reflektierten Licht resultiert. Das reflektierte Lichtmuster wird mittels eines ersten f-θ Linsensystems auf einen Drehspiegel projiziert, welcher dazu dient, das Lichtmuster durch ein zweites f-θ Linsensystem über eine Objektoberfläche zu scannen.

Aufgabe der vorliegenden Erfindung ist es, in einem Verfahren und/oder in einer Vorrichtung zur Bebilderung eines strahlungsempfindlichen Substrats die Bildauflösung zu steigern und/oder die Geschwindigkeit der Belichtung zu erhöhen.

Diese Aufgabe wird erfindungsgemäß durch ein Verfahren zur Bebilderung eines strahlungsempfindlichen Substrats mit den Merkmalen gemäß Anspruch 1 und/oder durch eine Vorrichtung zur Bebilderung eines strahlungsempfindlichen Substrats gemäß Anspruch 8 gelöst. Vorteilhafte Weiterbildungen sind in den abhängigen Ansprüchen charakterisiert.

Das erfindungsgemäße Verfahren und/oder die erfindungsgemäße Vorrichtung erreichen eine Steigerung der Auflösung ohne Reduktion der Bebilderungsgeschwindigkeit.

Das erfindungsgemäße Verfahren und die erfindungsgemäße Vorrichtung verzichten auf mehrfache Belichtungen und die dazu notwendigen mechanischen Bewegungsvorgänge, sondern benutzen eine akustisch-optische oder elektro-optische Ablenkeinheit zur Verschiebung der Projektion auf dem Substrat. Durch diese Verschiebung wird die auf dem Substrat deponierte Strahlungsenergie je Vorlagenelement genauer kontrolliert und ermöglicht dadurch eine höhere Ortsauflösung bei der Platzierung von Strukturkanten.

Im erfindungsgemäßen Verfahren zur Bebilderung eines strahlungsempfindlichen Substrats wird eine programmierbare Vorlage auf das strahlungsempfindliche Substrat unter Verwendung kohärenter Strahlung mit einer Wellenlänge, bei der das Substrat strahlungsempfindlich ist, projiziert. Ein gesamtes Bild der programmierbaren Vorlage, insbesondere mit einem Bildraster, wird simultan oder gleichzeitig durch eine akustisch-optische oder elektro-optische Ablenkeinheit derart verschoben, dass mehrfache Projektionen an verschiedenen Positionen auf dem Substrat auftreffen, so dass ein feines Teilraster im Bildraster auf dem Substrat erzeugt wird.

Die programmierbare Vorlage kann insbesondere reflexiv oder ein reflexives optisches Element beziehungsweise nicht transmissiv oder opak sein. Die Reflexion der Vorlage kann programmierbar oder einstellbar sein. Innerhalb eines gesamten Bildes kann die kohärente Strahlung Interferenzerscheinungen zeigen. Das gesamte Bild kann aus miteinander interferierenden Strahlenbündeln bestehen oder zusammengesetzt sein.

Es wird mehrfach das gesamte Bild der programmierbaren Vorlage auf dem strahlungsempfindlichen Substrat abgebildet. Die Länge der Verschiebung für die Erzeugung eines Teilrasters ist kleiner als die Weite des Bildrasters.

Die programmierbare Vorlage ist aus einem eindimensionalen Raster oder einem zweidimensionalen Raster von Modulator-Elementen aufgebaut. Insbesondere kann mittels der Modulator-Elemente die Richtung und/oder die Amplitude der kohärenten Strahlung verändert werden

In einer ersten Gruppe von Realisierungen des erfindungsgemäßen Verfahrens wird eine Strahlungsquelle mit zeitlich kontinuierlicher Ausgangsleistung verwendet. In einer zweiten Gruppe von Realisierungen wird eine Strahlungsquelle mit zeitlich gepulster Ausgangsleistung verwendet.

Mittels der akustisch-optischen oder elektro-optischen Ablenkeinheit kann eine Mehrzahl von Strahlenbündeln simultan oder gleichzeitig verschoben werden. Des Weiteren kann der Beleuchtungswinkel der programmierbaren Vorlage zur Einstellung der Phasenlage des auf das strahlungsempfindliche Substrat einfallenden Lichts verändert oder eingestellt werden.

Eine erfindungsgemäße Vorrichtung zur Bebilderung eines strahlungsempfindlichen Substrats enthält das strahlungsempfindliche Substrat, eine Strahlungsquelle zur Emission kohärenter Strahlung mit einer Wellenlänge, bei der das Substrat strahlungsempfindlich ist, eine programmierbare Vorlage und ein optisches System zur Projektion der von der kohärenten Strahlung beleuchteten programmierbaren Vorlage auf das strahlungsempfindliche Substrat. Des Weiteren weist die erfindungsgemäße Vorrichtung eine akustisch-optische oder elektro-optische Ablenkeinheit, die zur simultanen Verschiebung eines gesamten Bildes der programmierbaren Vorlage mit einem Bildraster derart angesteuert ist, dass mehrfache Projektionen zur Erzeugung eines feinen Teilrasters im Bildraster auf dem Substrat an verschiedenen Positionen auf dem Substrat auftreffen.

Bevorzugt für die erfindungsgemäße Vorrichtung zur Bebilderung eines strahlungsempfindlichen Substrats ist dabei die programmierbare Vorlage aus Modulator-Elementen aufgebaut, wobei die Modulator-Elemente von einem Mikrospiegelarray oder von einer eindimensionalen Anordnung von steuerbaren Beugungsgittern gebildet werden.

Die Strahlungsquelle, insbesondere eine Laserlichtquelle, emittiert bevorzugt Licht mit einer Wellenlänge zwischen 180 nm und 430 nm, insbesondere zwischen 240 nm und 400 nm, bevorzugt zwischen 340 und 395 nm. In der Ausführung als Laserlichtquelle kann es sich um einen frequenzvervielfachten Laser, insbesondere einen frequenzverdoppelten Laser handeln. Die in der erfindungsgemäßen Vorrichtung verwendete Strahlungsquelle kann insbesondere Licht im ultravioletten Spektralbereich, insbesondere UV-A, UV-B oder UV-C, emittieren.

Das erfindungsgemäße Verfahren wird mit Hilfe eines Steuerungsablaufs oder eines Steuerungsprogramms für eine Steuerungseinheit oder einen Steuerungsrechner der erfindungsgemäßen Vorrichtung realisiert. Anders gesagt, die Vorrichtung umfasst eine Steuerungseinheit, insbesondere einen Steuerungscomputer mit einem Speicher, in welchem ein Computerprogramm abgelegt ist, mit wenigstens einem Teil, der eine Ansteuerung der Vorrichtung bewirkt, so dass ein Verfahren mit Merkmalen oder Merkmalskombinationen gemäß dieser Darstellung mit der Vorrichtung durchgeführt wird.

Die in dieser Darstellung beschriebenen Merkmale können einzeln, in Kombinationen mehrerer einzelner Merkmale oder alle gemeinsam in einer erfindungsgemäßen Vorrichtung beziehungsweise einem erfindungsgemäßen Verfahren verwirklicht sein. Die Erfindung wird durch die Patentansprüche definiert.

Weitere Vorteile und vorteilhafte Ausführungsformen und Weiterbildungen der Erfindung werden anhand der nachfolgenden Beschreibung unter Bezugnahme auf die Figuren dargestellt. Es zeigt im Einzelnen:
- Figur 1: eine Übersicht einer Ausführungsform der erfindungsgemäßen Vorrichtung zur Bebilderung eines strahlungsempfindlichen Substrats,
- Figur 2: ein Detail der Ausführungsform der erfindungsgemäßen Vorrichtung zur Bebilderung eines strahlungsempfindlichen Substrats,
- Figur 3: eine Intensitätsverteilung auf einem Substrat mit Interferenzen, und
- Figur 4: eine Intensitätsverteilung auf einem Substrat nach mehrfachen Projektionen.

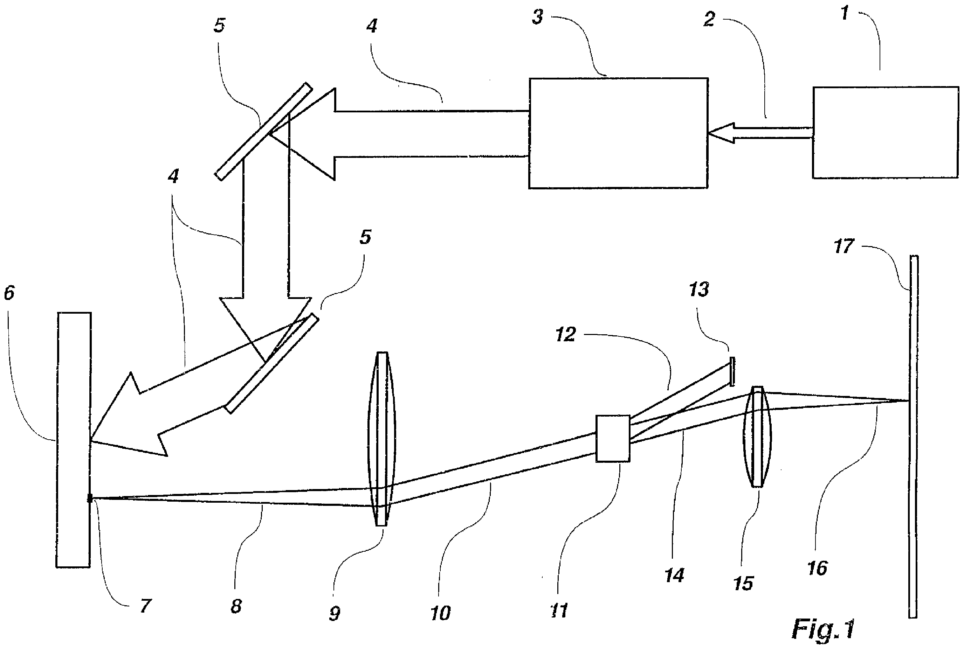

Der Aufbau einer Ausführungsform der erfindungsgemäßen Vorrichtung zur Bebilderung eines strahlungsempfindlichen Substrats 17, auch als Belichtungssystem bezeichnet, geht aus Figur 1 hervor. Die Strahlungsquelle 1 der kohärenten Strahlung ist als Laser bei einer Wellenlänge von circa 355 nm ausgeführt. Das austretende Strahlungsfeld 2 wird mit Hilfe der Optik 3 (Aufweitungsoptik) so aufgeweitet, dass alle steuerbaren Modulator-Elemente der programmierbaren Vorlage 6 beleuchtet werden können. Je nach mechanischem Aufbau sind hierzu gegebenenfalls mehrere Spiegel 5 notwendig, um das aufgeweitete Strahlungsfeld 4 auf die programmierbare Vorlage 6 zu lenken.

Zur Vereinfachung von Figur 1 wird angenommen, dass alle dargestellten Komponenten sich in der Zeichenebene befinden. Bei der Realisierung sind jedoch die Komponenten des Beleuchtungsstrahlengang, insbesondere die Spiegel 5 und das Strahlenbündel 4, nicht zwingend in der Ebene der Projektionsoptik, Linse 9 und Linse 15.

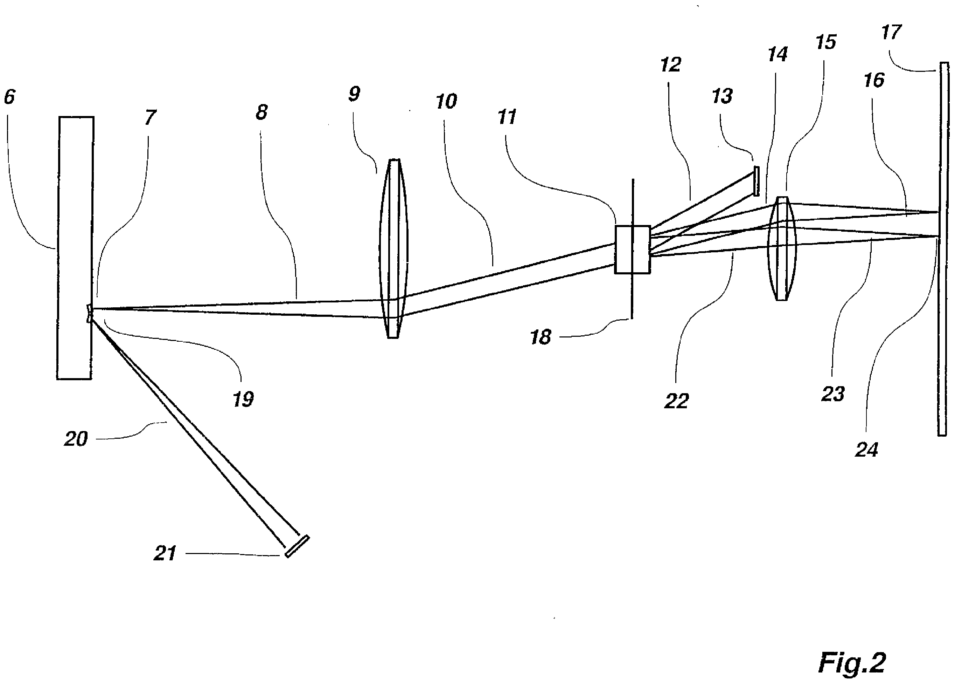

Die programmierbare Vorlage 6 besteht aus einer Vielzahl von Modulator-Elementen 7. Diese sind in der programmierbaren Vorlage 6 in einem regelmäßigen Raster angeordnet. Das Raster der programmierbaren Vorlage 6 wird, entsprechend dem Verhältnis der Brennweiten der Linse 9 und Linse 15, skaliert auf dem Substrat 17 abgebildet. Jedes dieser Modulator-Elemente 7 lässt sich entsprechend der zu erzeugenden Muster ansteuern. Das gezeichnete Modulator-Element 7 ist aktiviert, so dass ein Teil der einfallenden Strahlung in Richtung Substrat gelenkt wird. Nicht aktivierte Modulator-Elemente lenken ihren Teilstrahl nicht in Richtung des Substrates, Details in Figur 2. Die Teilstrahlen 8 der aktiven Modulator-Elemente treffen Linse 9. Der Abstand der Linse 9 zur programmierbaren Vorlage 6 entspricht der Brennweite der Linse.

Ohne Einschränkung der Allgemeinheit kann die Linse 9 und/oder die Linse 15 jeweils durch eine Linsengruppe ausgeführt sein, um die erforderliche optische Auflösung zu erhalten.

Aufgrund der Beugung am Modulator-Element 7 ist der Teilstrahl 8 divergent und wird durch die Linse 9 in ein paralleles Strahlungsbündel umgewandelt. Sämtliche einfallenden Teilstrahlen sind parallel, daher schneiden sich die ausgangsseitigen Strahlenbündel 10 in der Brennebene 18 der Linse 9, siehe auch Figur 2.

Nicht aktivierte Modulator-Elemente 19 der programmierbaren Vorlage 6 lenken das Strahlenbündel 20 in eine andere Richtung, so dass es nicht auf Linse 9 trifft, sondern von einem Absorber 21 aus dem weiteren Strahlengang entfernt wird.

In der Brennebene 18 ist die akustisch-optische Ablenkeinheit 11 angeordnet, deren Arbeitsweise und Bauart bekannt sind. Nicht zeichnerisch dargestellt ist eine Steuerungseinheit für die Ablenkungseinheit 11. Die Steuerungseinheit bewirkt die Ansteuerung der Ablenkungseinheit 11, insbesondere die simultane Verschiebung eines gesamten Bildes der programmierbaren Vorlage mit einem Bildraster. Die Steuerungseinheit kann insbesondere ein Steuerungscomputer sein oder gesteuert von einem Computer sein. Ist kein elektrisches Signal an der Ablenkeinheit 11 angelegt, so treten die einfallenden Strahlenbündel als Bündel nullter Ordnung 12 aus. Diese Strahlung wird durch den Absorber 13 aus dem Strahlengang entfernt. Liegt ein elektrisches Signal mit passend gewählter Frequenz an, so treten die eingestrahlten Bündel 10 als Bündel erster Ordnung 14 aus und treffen Linse 15. Die Position der Linse 15 ist so gewählt, dass die eingangsseitige Brennebene mit Brennebene 18 zusammenfällt. Das strahlungsempfindliche Substrat befindet sich in der ausgangsseitigen Brennebene der Linse 15. Linse 15 fokussiert die einfallenden Strahlenbündel auf dem Substrat. In Abhängigkeit des Einfallswinkels des Strahlenbündels 14 in die Linse 15 ergibt sich die Position des Bildes des aktiven Modulator-Elementes.

In Figur 2 sind die Details des Strahlengangs um die akustisch-optischen Ablenkeinheit 11 dargestellt. Wird ein elektrisches Signal mit einer anderen Frequenz als in Figur 1 angenommen, an die akustisch-optische Ablenkeinheit angelegt, so ändert sich die Richtung des aus der Ablenkeinheit austretenden Strahlenbündels 22. Da das Strahlenbündel 22 einen anderen Einfallswinkel in die Linse 15 besitzt wie das Strahlenbündel 14, ergibt sich eine geänderte Position 24 des Bildes des aktiven Modulator-Elements auf dem Substrat 17.

In Figur 1 und 2 ist zur Übersichtlichkeit nur ein aktives Modulator-Element dargestellt. Die programmierbare Vorlage besteht aus vielen dieser Elemente. Wird als programmierbare Vorlage 6 beispielsweise ein Mikrospiegelarray, TI DMD 3000, verwendet, so stehen 1.024 Elemente in einer horizontaler Zeile zur Verfügung. Insgesamt besteht dieses Mikrospiegelarray aus 768 Zeilen und stellt damit eine zweidimensionale programmierbare Vorlage 6 mit 786.432 individuell ansteuerbaren Modulator-Elementen 7 dar.

Eine andere Ausführung der programmierbaren Vorlage 6 besteht aus einer eindimensionalen Anordnung von steuerbaren Beugungsgittern bekannter Bauart. Diese Art der programmierbaren Vorlage 6 stellt beispielsweise 1.088 individuell ansteuerbare Modulator-Elemente 7 zur Verfügung.

Beiden programmierbaren Vorlagen 6 ist gemeinsam, dass sie aus individuell steuerbaren Modulator-Elementen aufgebaut sind. Jedes dieser Modulator-Elemente erzeugt ein kohärentes Lichtbündel, wenn es aktiviert ist. Linse 9 sammelt diese einfallenden Bündel 10 und fokussiert diese auf die Ablenkeinheit 11.

Im Gegensatz zur üblichen Anwendung der akustisch-optischen Ablenkeinheit, bei der nur ein zentral einfallendes Strahlenbündel entsprechend der angelegten Frequenz des elektrischen Signals abgelenkt wird, kommt es in der beschriebenen Anordnung zu einer Verschiebung eines gesamten Bildes. Wird bei der ursprünglichen Anwendung auf einen möglichst großen Ablenkwinkel Wert gelegt, so wird bei der hier beschriebenen Anordnung ein möglichst großer Einfallswinkel ausgenutzt. Neben den bisher erwähnten akustisch-optischen Ablenkeinheiten AOD, welche die Wechselwirkung zwischen Ultraschall, Phononen und Licht, Photonen, ausnutzen, ist es erfindungsgemäß möglich, Ablenkeinheiten einzusetzen, welche zur Strahlablenkung geeignet sind und beispielsweise bevorzugt auf dem elektro-optischen Effekt basieren. Durch Anlegen einer Spannung ändert sich der Brechungsindex bestimmter Kristalle und die hindurch tretende Strahlung erfährt eine Richtungsänderung.

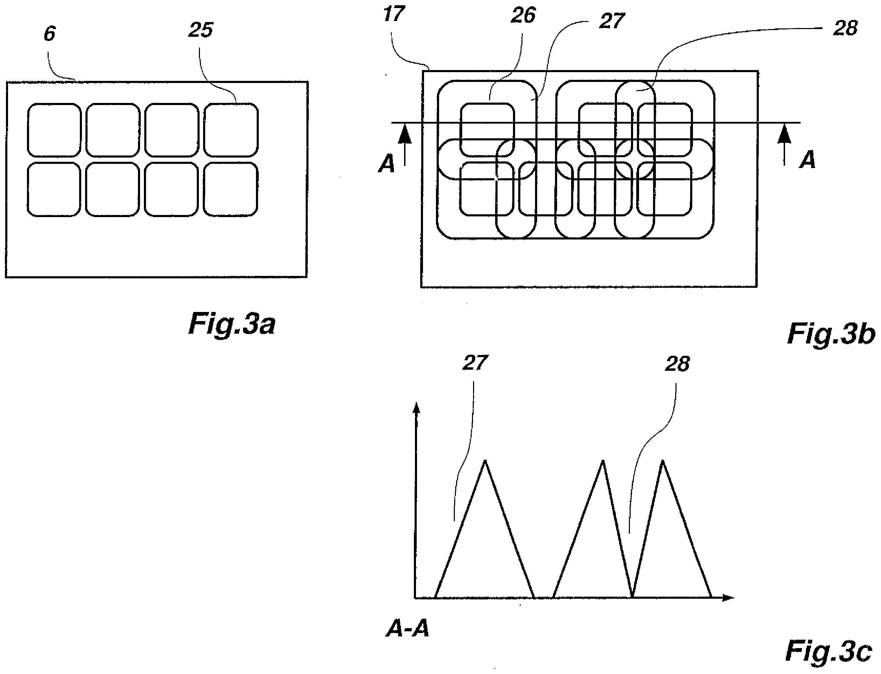

In Figur 3 wird dargestellt, welche Intensität-Verteilung sich auf dem Substrat 17 einstellt, wenn sich kohärente Strahlungsbündel bei geringer optischer Auflösung überlagern. In Figur 3a ist zunächst eine Aufsicht der programmierbaren Vorlage 6 mit den einzeln ansteuerbaren Modulator-Elementen 25 gezeigt. Nach der Abbildung durch Linse 9 und Linse 15 sind die geometrischen Einzelbilder 26 der Modulator-Elemente auf dem Substrat 17 in Figur 3b gezeichnet. Hierbei wurde die Situation angenommen, dass ein Modulator-Element nicht angesteuert wurde und somit kein Bild in Figur 3b erzeugt.

Durch die endliche optische Auflösung des optischen Systems aus Linse 9 und Linse 15 ergibt sich eine teilweise Überlagerung der kohärenten Strahlungsbündel 27. In den Überlagerungsbereichen 28 tritt Interferenz auf, da die sich überlagernden Strahlenbündei eine feste Phasenbeziehung besitzen.

In Figur 3c ist schematisch vereinfacht die resultierende Intensität entlang des Schnittes A-A dargestellt. Im Überlagerungsbereich 28 wird die resultierende Intensität von der Phasenlage der einfallenden Felder bestimmt. Durch die Wahl oder Einstellung des Beleuchtungswinkels, bestimmt durch die Anordnung des Spiegels 5, insbesondere die einstellbare oder veränderbare Anordnung des Spiegels 5, vor der programmierbaren Vorlage 6, kann die Phasenlage so eingestellt werden, dass sich die Felder im Überlagerungsbereich 28 vollständig auslöschen, siehe Figur 3c.

Die Auslöschung der Belichtungsintensität führt zu starken Schwankungen der Position von Strukturkanten. Um dies zu verhindern, wird erfindungsgemäß vorgeschlagen, auf jede zu belichtende Fläche mehrfach das Bild der programmierbaren Vorlage 6 abzubilden und dabei das Bild mit Hilfe der Ablenkvorrichtung 11 innerhalb des Bildrasters 30 zu verschieben. Da die Belichtungsvorgänge zeitlich versetzt erfolgen, kann es zu keiner Interferenz zwischen den Strahlungsfeldern kommen, die Strahlungsintensitäten der einzelnen Belichtungen addieren sich daher.

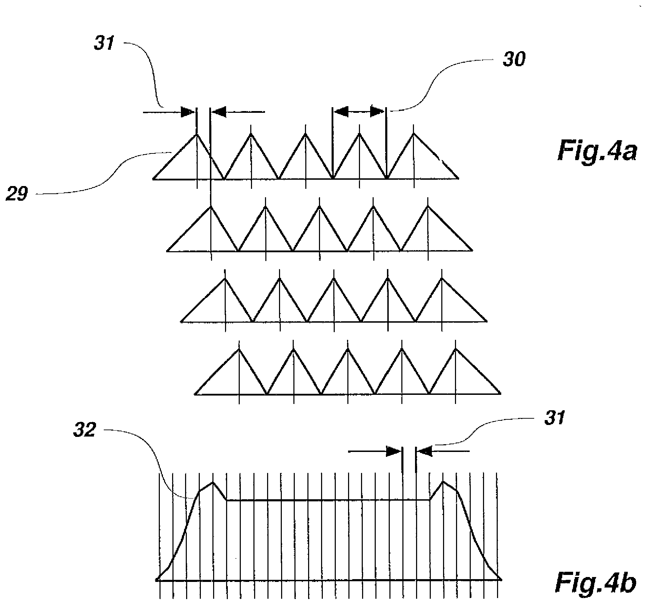

In Figur 4a sind vier Intensitätsverteilungen 29 dargestellt, die zeitlich nacheinander auf das Substrat projiziert werden. Jede Intensitätsverteilung 29 ergibt sich aus der Interferenz der sich überlappenden kohärenten Strahlungsbündel 27. Deutlich erkennbar sind die im Bildraster 30 auftretenden Intensitätsmaxima und Intensitätsminima. Jede Teilbelichtung wird um ein Teilraster 31 gegenüber dem grundlegenden Bildraster 30 verschoben. Die Länge oder Distanz der Verschiebung ist kleiner als die Weite des Bildrasters 30. Das Teilraster 31 ist insbesondere feiner als das Bildraster 30.

Der Betrag der Verschiebung der Strahlenbündel 27 zwischen einer ersten Projektion und einer zweiten Projektion ist derart klein, dass Intensitätsmaxima in der zweiten Projektion in Bereichen zwischen benachbarten Intensitätsmaxima der ersten Projektion durch diejenigen

Strahlenbündel erzeugt werden, welche zu den benachbarten Intensitätsmaxima in der ersten Projektion beigetragen haben.

In Figur 4b ist die resultierende Intensitätsverteilung 32 dargestellt, welche eine Auflösung entsprechend dem Teilraster 31 besitzt. Die Intensitätsverteilung 32 zeigt keine Intensitätsschwankungen im Bildraster 30. Die Überhöhungen am Anfang und Ende der Intensitätsverteilung 32 resultieren aus dem Verlauf der Intensität, der sich ergibt, wenn keine Interferenz mit benachbarten Strahlenbündeln auftritt, und lassen sich durch geeignete Wahl der Strahlungsdosis dieser Bildpunkte reduzieren.

Das erfindungsgemäße Verfahren sowie die Vorrichtung zeichnen sich insbesondere dadurch aus, dass eine Ablenkeinheit, welche insbesondere als eine akustisch-optische Ablenkeinheit oder als eine elektro-optische Ablenkeinheit ausgebildet ist, dazu verwendet wird, ein gesamtes Bild, das heisst, eine Vielzahl von Strahlenbündel simultan, zu verschieben.

### Bezugszeichen liste

- 1: Strahlungsquelle
- 2: Strahlungsfeld
- 3: Optik
- 4: aufgeweitetes Strahlungsfeld
- 5: Spiegel
- 6: programmierbare Vorlage
- 7: aktives Modulator-Element
- 8: divergierendes Strahlenbündel
- 9: Linse
- 10: paralleles Strahlenbündel
- 11: Ablenkeinheit
- 12: Strahlenbündel nullter Ordnung
- 13: Absorber
- 14: Strahlenbündel erster Ordnung
- 15: Linse
- 16: fokussiertes Strahlenbündel
- 17: strahlungsempfindliches Substrat
- 18: Brennebene
- 19: inaktives Modulator-Element
- 20: Strahlenbündel
- 21: Absorber
- 22: Strahlenbündel abgelenkt
- 23: abgelenktes Strahlenbündel
- 24: Bildpunkt
- 25: Draufsicht auf Modulator-Element
- 26: geometrisches Bild eines Modulator-Elements
- 27: beugungsbedingtes Bild eines Modulator-Elements
- 28: Überlagerungsbereich
- 29: Intensitätsverteilung
- 30: Bildraster
- 31: Teilraster
- 32: Intensitätssumme

## Patentansprüche

1. Verfahren zur Bebilderung eines strahlungsempfindlichen Substrats (17), in welchem eine programmierbare Vorlage (6) auf das strahlungsempfindliche Substrat (17) unter Verwendung kohärenter Strahlung (2) mit einer Wellenlänge, bei der das Substrat (17) strahlungsempfindlich ist, projiziert wird,
**dadurch gekennzeichnet, dass**
ein gesamtes Bild der programmierbaren Vorlage (6) mit einem Bildraster (30) simultan durch eine akustisch-optische oder elektro-optische Ablenkeinheit (11) derart verschoben wird, dass mehrfache Projektionen an verschiedenen Positionen auf dem Substrat (17) auftreffen, so dass ein feines Teilraster (31) im Bildraster (30) auf dem Substrat (17) erzeugt wird,
- wobei mehrfach das gesamte Bild der programmierbaren Vorlage (6) auf dem strahlungsempfindlichen Substrat (17) abgebildet wird,
- wobei die Länge der Verschiebung für die Erzeugung eines Teilrasters (31) kleiner als die Weite des Bildrasters (30) ist,
- wobei die programmierbare Vorlage (6) aus einem eindimensionalen oder zweidimensionalen Raster von individuell steuerbaren Modulator-Elementen (7) aufgebaut ist,
- wobei das austretende Strahlungsfeld (2) mit Hilfe einer Optik (3) so aufgeweitet wird, dass alle steuerbaren Modulator-Elemente (7) der programmierbaren Vorlage (6) beleuchtet werden können,
- wobei jedes der Modulator-Elemente (7) ein kohärentes Lichtbündel oder Strahlenbündel (27) erzeugt, wenn es aktiviert wird, und
- wobei der Betrag der Verschiebung der Strahlenbündel (27) zwischen einer ersten Projektion und einer zweiten Projektion derart klein ist, dass Intensitätsmaxima in der zweiten Projektion in Bereichen zwischen benachbarten Intensitätsmaxima der ersten Projektion durch diejenigen Strahlenbündel erzeugt werden, welche zu den benachbarten Intensitätsmaxima in der ersten Projektion beigetragen haben.

2. Verfahren nach Anspruch 1, **dadurch gekennzeichnet, dass** mittels der Modulator-Elemente (7) die Richtung der kohärenten Strahlung (2) verändert wird.

3. Verfahren nach Anspruch 1 oder 2, **dadurch gekennzeichnet, dass** mittels der Modulator-Elemente (7) die Amplitude der kohärenten Strahlung (2) verändert wird.

4. Verfahren nach einem der Ansprüche 1 bis 3, **dadurch gekennzeichnet, dass** eine Strahlungsquelle (1) mit zeitlich kontinuierlicher Ausgangsleistung verwendet wird.

5. Verfahren nach einem der Ansprüche 1 bis 3, **dadurch gekennzeichnet, dass** eine Strahlungsquelle (1) mit zeitlich gepulster Ausgangsleistung verwendet wird.

6. Verfahren nach einem der vorstehenden Ansprüche, **dadurch gekennzeichnet, dass** eine Mehrzahl von Strahlenbündeln mittels der akustisch-optischen oder elektro-optischen Ablenkeinheit (11) simultan verschoben wird.

7. Verfahren nach einem der vorstehenden Ansprüche, **dadurch gekennzeichnet, dass** der Beleuchtungswinkel der programmierbaren Vorlage (6) zur Einstellung der Phasenlage des auf das strahlungsempfindliche Substrat (17) einfallenden Lichts verändert wird.

8. Vorrichtung zur Bebilderung eines strahlungsempfindlichen Substrats (17), enthaltend das strahlungsempfindliche Substrat (17), eine Strahlungsquelle (1) zur Emission kohärenter Strahlung (2) mit einer Wellenlänge, bei der das Substrat (17) strahlungsempfindlich ist, eine programmierbare Vorlage (6) und ein optisches System zur Projektion der von der kohärenten Strahlung beleuchteten programmierbaren Vorlage (6) auf das strahlungsempfindliche Substrat (17),
**gekennzeichnet durch** eine akustisch-optische oder elektro-optische Ablenkeinheit (11), die zur simultanen Verschiebung eines gesamten Bildes der programmierbaren Vorlage (6) mit einem Bildraster (30) derart angesteuert ist, dass mehrfache Projektionen zur Erzeugung eines feinen Teilrasters (31) im Bildraster (30) auf dem Substrat (17) an verschiedenen Positionen auf dem Substrat (17) auftreffen,
wobei die Vorrichtung eine Steuerungseinheit umfasst, die eine Ansteuerung der Vorrichtung bewirkt, so dass ein Verfahren gemäß einem der vorstehenden Ansprüche 1 bis 7 mit der Vorrichtung durchgeführt wird.

9. Vorrichtung zur Bebilderung eines strahlungsempfindlichen Substrats (17) gemäß Anspruch 8, **dadurch gekennzeichnet, dass** die programmierbare Vorlage (6) aus Modulator-Elementen (7) aufgebaut ist, wobei die Modulator-Elemente (7) von einem Mikrospiegelarray gebildet werden.

10. Vorrichtung zur Bebilderung eines strahlungsempfindlichen Substrats (17) gemäß Anspruch 8, **dadurch gekennzeichnet, dass** die programmierbare Vorlage (6) aus Modulator-Elementen (7) aufgebaut ist, wobei die Modulator-Elemente (7) von einer eindimensionalen Anordnung von steuerbaren Beugungsgittern gebildet werden.

11. Vorrichtung zur Bebilderung eines strahlungsempfindlichen Substrats (17) gemäß einem der vorstehenden Ansprüche 8 bis 10, **dadurch gekennzeichnet, dass** die Strahlungsquelle (1) Licht mit einer Wellenlänge zwischen 180 nm und 430 nm emittiert.

## Claims

1. A method for imaging a radiation-sensitive substrate (17), in which a programmable template (6) is projected onto the radiation-sensitive substrate (17) using coherent radiation (2) having a wavelength at which the substrate (17) is radiation-sensitive,
**characterised in that**
an overall image of the programmable template (6) with an image grid (30) is displaced simultaneously by an acoustic-optical or electro-optical deflection unit (11) such that multiple projections impinge at different positions on the substrate (17) such that a fine partial grid (31) is generated in the image grid (30) on the substrate (17),
wherein the overall image of the programmable template (6) is reproduced multiple times on the radiation-sensitive substrate (17),
wherein the length of the displacement for generating a partial grid (31) is smaller than the width of the image grid (30),
wherein the programmable template (6) is constructed from a one-dimensional or two-dimensional grid of individually controllable modulator elements (7),
wherein the exiting radiation field (2) is expanded using optics (3) such that all the controllable modulator elements (7) of the programmable template (6) can be illuminated,
wherein each of the modulator elements (7) generates a coherent light beam or radiation beam (27) when it is activated, and
wherein the amount by which the radiation beam (27) is displaced between a first projection and a second projection is so small that intensity maxima are generated in the second projection in regions between adjacent intensity maxima of the first projection by the radiation beams which have contributed to the adjacent intensity maxima in the first projection.

2. The method according to Claim 1,
**characterised in that**
the direction of the coherent radiation (2) is changed by means of the modulator elements (7).

3. The method according to Claim 1 or 2,
**characterised in that**
the amplitude of the coherent radiation (2) is changed by means of the modulator elements (7).

4. The method according to any one of Claims 1 to 3,
**characterised in that**
a radiation source (1) with a chronologically constant output power is used.

5. The method according to any one of Claims 1 to 3,
**characterised in that**
a radiation source (1) with a chronologically pulsed output power is used.

6. The method according to any one of the preceding claims,
**characterised in that**
a plurality of radiation beams is displaced simultaneously by means of the acoustic-optical or electro-optical deflection unit (11).

7. The method according to any one of the preceding claims,
**characterised in that**
the illumination angle of the programmable template (6) is changed to set the phase position of the light incident on the radiation-sensitive substrate (17).

8. A device for imaging a radiation-sensitive substrate (17), containing the radiation-sensitive substrate (17), a radiation source (1) for emitting coherent radiation (2) having a wavelength at which the substrate (17) is radiation-sensitive, a programmable template (6) and an optical system for projecting the programmable template (6) illuminated by the coherent radiation onto the radiation-sensitive substrate (17), **characterised by** an acoustic-optical or electro-optical deflection unit (11) which, for simultaneous displacement of an overall image of the programmable template (6) with an image grid (30), is activated such that multiple projections impinge at different positions on the substrate (17) to generate a fine partial grid (31) in the image grid (30) on the substrate (17),
wherein the device comprises a control unit which effects activation of the device such that a method according to any one of the preceding claims 1 to 7 is carried out with the device.

9. The device for imaging a radiation-sensitive substrate (17) according to Claim 8,
**characterised in that**
the programmable template (6) is constructed from modulator elements (7), wherein the modulator elements (7) are formed from a micromirror array.

10. The device for creating an image on a radiation-sensitive substrate (17) according to Claim 8,
**characterised in that**
the programmable template (6) is constructed from modulator elements (7), wherein the modulator elements (7) are formed from a one-dimensional arrangement of controllable diffraction gratings.

11. The device for imaging a radiation-sensitive substrate (17) according to any one of the preceding Claims 8 to 10,
**characterised in that**
the radiation source (1) emits light having a wavelength between 180 nm and 430 nm.

## Revendications

1. Procédé, destiné à produire des images sur un substrat (17) sensible au rayonnement, lors duquel on projette un modèle (6) programmable sur le substrat (17) sensible au rayonnement en utilisant un rayonnement (2) cohérent, d'une longueur d'onde à laquelle le substrat (17) est sensible au rayonnement, **caractérisé en ce qu'**on déplace une image globale du modèle (6) simultanément avec une trame d'image (30) à l'aide d'une unité de déviation (11) acousto-optique ou électro-optique, de telle sorte que des projections multiples soient incidentes sur différentes positions sur le substrat (17), de sorte à créer une fine trame partielle (31) dans la trame d'image (30) sur le substrat (17), lors duquel on reproduit à plusieurs reprises l'image globale du modèle (6) programmable sur le substrat (17) sensible au rayonnement,
la longueur du déplacement destiné à créer une trame partielle (31) étant inférieure à l'étendue de la trame d'images (30),
le modèle (6) programmable étant conçu en une trame unidimensionnelle ou bidimensionnelle d'éléments modulateurs (7) susceptibles d'être commandés individuellement ,
lors duquel on élargit le champ de rayonnement (2) à l'aide d'une optique (3), de manière que tous les éléments modulateurs (7) susceptibles d'être commandés du modèle (6) programmable puissent être éclairés, lorsqu'on l'active, chacun des éléments modulateurs (7) générant un faisceau lumineux ou faisceau de rayons (27) cohérent, et
le montant du déplacement des faisceaux de rayons (27) entre une première projection et une deuxième projection étant si faible que des maximas d'intensité dans la deuxième projection soient générés dans des plages entre des maximas d'intensité voisins de la première projection par les faisceaux de rayons qui ont contribué aux maximas d'intensité voisins dans la première projection.

2. Procédé selon la revendication 1, **caractérisé en ce qu'**au moyen des éléments modulateurs (7), on fait varier la direction du rayonnement (2) cohérent.

3. Procédé selon la revendication 1 ou 2, **caractérisé en ce qu'**au moyen des éléments modulateurs (7), on fait varier l'amplitude du rayonnement (2) cohérent.

4. Procédé selon l'une quelconque des revendications 1 à 3, **caractérisé en ce qu'**on utilise une source de rayonnement (1) à puissance de sortie continue dans le temps.

5. Procédé selon l'une quelconque des revendications 1 à 3, **caractérisé en ce qu'**on utilise une source de rayonnement (1) à puissance de sortie pulsée dans le temps.

6. Procédé selon l'une quelconque des revendications précédentes, **caractérisé en ce qu'**on déplace simultanément une pluralité de faisceaux de rayons à l'aide de l'unité de déviation (11) acousto-optique ou électro-optique.

7. Procédé selon l'une quelconque des revendications précédentes, **caractérisé en ce qu'**on fait varier l'angle d'éclairage du modèle (6) programmable pour le réglage de la position de phase de la lumière incidente sur le substrat (17) sensible au rayonnement.

8. Dispositif, destiné à produire des images sur un substrat (17) sensible au rayonnement, contenant le substrat (17) sensible au rayonnement, une source de rayonnement (1) pour l'émission d'un rayonnement (2) cohérent à une longueur d'onde, à laquelle le substrat (17) est sensible au rayonnement, un modèle (6) programmable et un système optique pour la projection du modèle (6) programmable éclairé par le rayonnement cohérent sur le substrat (17) sensible au rayonnement, **caractérisé par** une unité de déviation (11) acousto-optique ou électro-optique, qui pour le déplacement simultané d'un image globale du modèle (6) programmable avec une trame d'image (30) est actionné de telle sorte, que pour créer une fine trame partielle (31) dans la trame d'image sur le substrat (17), des projections multiples (30) soient incidentes sur différentes positions sur le substrat (17), le dispositif comprenant une unité de commande qui provoque un actionnement du dispositif, de sorte qu'à l'aide du dispositif soit réalisé un procédé selon l'une quelconque des revendications 1 à 7 précédentes.

9. Dispositif, destiné à produire des images sur un substrat (17) sensible au rayonnement selon la revendication 8, **caractérisé en ce que** le modèle (6) programmable est conçu en éléments modulateurs (7), les éléments modulateurs (7) étant formés par une matrice de micro-miroirs.

10. Dispositif, destiné à produire des images sur un substrat (17) sensible au rayonnement selon la revendication 8, **caractérisé en ce que** le modèle (6) programmable est conçu en éléments modulateurs (7), les éléments modulateurs (7) étant formés par un agencement monodimensionnel de réseaux de diffraction susceptibles d'être commandés.

11. Dispositif, destiné à produire des images sur un substrat (17) sensible au rayonnement selon l'une quelconque des revendications 8 à 10 précédentes, **caractérisé en ce que** la source de rayonnement (1) émet de la lumière à une longueur d'onde comprise entre 180 nm et 430 nm.
